(19) Europäisches Patentamt
European Patent Office
Office européen des brevets

(11) **EP 4 742 531 A1**

(12) **EUROPEAN PATENT APPLICATION**

(43) Date of publication:
**13.05.2026   Bulletin 2026/20**

(21) Application number: **25213532.2**

(22) Date of filing: **05.11.2025**

(51) International Patent Classification (IPC):
**H03F 1/32** (2006.01)    **H03F 3/19** (2006.01)
**H03F 3/24** (2006.01)    **H04B 1/04** (2006.01)

(52) Cooperative Patent Classification (CPC):
**H03F 1/3247; H03F 1/3258; H03F 3/19;**
**H03F 3/245; H04B 1/0475;** H03F 2200/451;
H04B 2001/0425

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority:  **08.11.2024  FI 20246319**

(71) Applicant: **Nokia Solutions and Networks Oy**
**02610 Espoo (FI)**

(72) Inventors:
• **STEDILE-RIBEIRO, Thales**
**Stuttgart (DE)**
• **JELONNEK, Björn**
**Ulm (DE)**
• **FELGENTREFF, Tilman**
**Holzkirchen (DE)**

(74) Representative: **Nokia EPO representatives**
**Nokia Technologies Oy**
**Karakaari 7**
**02610 Espoo (FI)**

(54) **DIGITAL PRE-DISTORTION**

(57)     An apparatus for digital pre-distortion of a real valued signal in a real domain not a complex domain to produce a pre-distorted real valued signal (30), wherein digital pre-distortion is performed based on a comparison between a feedback real-valued signal signal (123), a real-valued signal to be transmitted (121) and/or the pre-distorted version of this signal (30).

FIG. 8

**Description**

TECHNOLOGICAL FIELD

Examples of the disclosure relate to digital pre-distortion (DPD). Examples of the disclosure relate to digital pre-distortion (DPD) before power amplification.

BACKGROUND

Power amplifiers (PAs) are efficient at nonlinear operating points. It is desirable to linearize the PA output so that they operate efficiently while meeting linearity specifications. One way to achieve a linearized PA output is by pre-distorting the input signal to the PA, so that the signal output from the PA meets the specified linearity.

Pre-distortion can, for example, create signal distortion components with controlled (frequency dependent) amplitude and phase that is the complement of the signal distortion inherent at the PA. The objective is that distortion at the PA negates the introduced distortion producing a near linear transfer characteristic.

BRIEF SUMMARY

The scope of protection sought for various example embodiments of the invention is set out by the independent claims. The example embodiments and features, if any, described in this specification that do not fall under the scope of the independent claims are to be interpreted as examples useful for understanding various example embodiments of the invention.

According to various, but not necessarily all, examples there is provided an apparatus. The apparatus may comprise a digital signal processor circuitry comprising a DPD circuitry; a power amplifier; at least one processor; and at least one memory comprising instructions which, when executed by the at least one processor, cause the apparatus at least to: determine a pre-distorted real valued signal, wherein the determination of the pre-distorted real valued signal comprises: applying a digital pre-distortion in a real domain to a real-valued input signal to obtain the pre-distorted real valued signal to be transmitted to the power amplifier; measuring an output of the power amplifier representative of a distorted real-valued signal; determining an error based on the distorted real-valued signal and at least one of the a) the real-valued input signal b) the digital pre-distorted signal; modifying the digital pre-distortion in the real domain based on the determined error.

In some but not necessarily all examples, the pre-distorted real valued signal is transmitted over a first bandwidth of transmission frequencies. And wherein the digital pre-distortion of the real valued signal in the real domain is configured to adapt a real valued signal for transmission at at least frequencies outside the first bandwidth that have a capability to have an effect within the first bandwidth.

In some but not necessarily all examples, wherein the real valued signal is a time-variable real valued signal and has a bandwidth from zero frequency (DC) to half the sampling frequency.

In some but not necessarily all examples, the pre-distorted real valued signal is provided, as a controlled waveform, directly from a digital signal processing block to a digital to analogue converter (DAC) at a target frequency as a real valued signal.

In some but not necessarily all examples, the pre-distorted real valued signal is provided directly to a digital to analogue converter (DAC) from a digital signal processor block, bypassing up-sampling and up-conversion blocks used for complex valued signals.

In some but not necessarily all examples, the pre-distorted real valued signal is configured to cancel even-order distortion at a power amplifier for a transmitting frequency, to linearize an output of the power amplifier at the transmitting frequency.

In some but not necessarily all examples, the pre-distorted real valued signal is configured to cancel even-order distortion and odd-order distortion at a power amplifier for a transmitting frequency, to linearize an output of the power amplifier at the transmitting frequency.

In some but not necessarily all examples, the pre-distorted real valued signal is configured to cancel odd-order distortion at a power amplifier for a transmitting frequency, to linearize an output of the power amplifier at the transmitting frequency.

In some but not necessarily all examples, the digital predistortion adapts coefficients for a model that generates the distorted components with an amplitude and phase capable of cancelling distortion generated by a power amplifier.

In some but not necessarily all examples, the pre-distorted real valued signal is transmitted over a first bandwidth of transmission frequencies, and, the digital pre-distortion in the real domain is configured to additionally adapt a signal for transmission at least at least frequencies below a frequency of the transmitted carrier of lowest frequency or above a frequency of the transmitted carrier of highest frequency.

In some but not necessarily all examples, the apparatus comprises: an input path for the pre-distorted real valued signal to a power amplifier wherein the input path is configured to have a bandwidth that is extended significantly beyond a transmission bandwidth.

In some but not necessarily all examples, the input path is configured to have a bandwidth that is extended significantly beyond a transmission bandwidth at frequencies below the transmission bandwidth.

In some but not necessarily all examples, the input path is configured to have a bandwidth that is extended to include DC.

In some but not necessarily all examples, the apparatus comprises: a matching network configured to allow low frequencies to reach a gate node of a power amplifier transistor.

In some but not necessarily all examples, the apparatus comprises: a transistor bias circuit configured to allow low frequencies coming from a power amplifier input to reach a gate node of a transistor of the power amplifier.

According to various, but not necessarily all, examples there is provided a method comprising: determining a pre-distorted real valued signal, wherein the determination of the pre-distorted real valued signal comprises: applying a digital pre-distortion in a real domain to a real-valued input signal to obtain the pre-distorted real valued signal to be transmitted to a power amplifier; measuring an output of the power amplifier representative of a distorted real-valued signal; determining an error based on the distorted real-valued signal and at least one of the a) the real-valued input signal b) the digital pre-distorted signal; modifying the digital pre-distortion in the real domain based on the determined error.

According to various, but not necessarily all, examples there is provided a computer program that when executed by one or more processors of the apparatus, enables:
determining a pre-distorted real valued signal, wherein the determination of the pre-distorted real valued signal comprises: applying a digital pre-distortion in a real domain to a real-valued input signal to obtain the pre-distorted real valued signal to be transmitted to a power amplifier; measuring an output of the power amplifier representative of a distorted real-valued signal; determining an error based on the distorted real-valued signal and at least one of the a) the real-valued input signal b) the digital pre-distorted signal; modifying the digital pre-distortion in the real domain based on the determined error.

According to various, but not necessarily all, examples there is provided an apparatus comprising means for: determining a pre-distorted real valued signal, wherein the determination of the pre-distorted real valued signal comprises: applying a digital pre-distortion in a real domain to a real-valued input signal to obtain the pre-distorted real valued signal to be transmitted to a power amplifier; measuring an output of the power amplifier representative of a distorted real-valued signal; determining an error based on the distorted real-valued signal and at least one of the a) the real-valued input signal b) the digital pre-distorted signal; modifying the digital pre-distortion in the real domain based on the determined error.

According to various, but not necessarily all, embodiments there is provided examples as claimed in the appended claims.

While the above examples of the disclosure and optional features are described separately, it is to be understood that their provision in all possible combinations and permutations is contained within the disclosure. It is to be understood that various examples of the disclosure can comprise any or all the features described in respect of other examples of the disclosure, and vice versa. Also, it is to be appreciated that any one or more or all the features, in any combination, may be implemented by/comprised in/performable by an apparatus, a method, and/or computer program instructions as desired, and as appropriate. The description of a function should additionally be considered to also disclose any means suitable for performing that function

BRIEF DESCRIPTION

Some examples will now be described with reference to the accompanying drawings in which:

FIG. 1 shows an example of the subject matter described herein;
FIG. 2 shows another example of the subject matter described herein;
FIG. 3A, 3B, 3C show examples of the subject matter described herein;
FIG. 3D, 3E, 3F, 3G show examples of the subject matter described herein;
FIG. 4 shows another example of the subject matter described herein;
FIG. 5A shows another example of the subject matter described herein;
FIG. 5B shows another example of the subject matter described herein;
FIG. 6A shows another example of the subject matter described herein;
FIG. 6B shows another example of the subject matter described herein;
FIG. 7 shows another example of the subject matter described herein;
FIG. 8 shows another example of the subject matter described herein;
FIG. 9 shows another example of the subject matter described herein;
FIG. 10 shows another example of the subject matter described herein.

The figures are not necessarily to scale. Certain features and views of the figures can be shown schematically or exaggerated in scale in the interest of clarity and conciseness. For example, the dimensions of some elements in the figures can be exaggerated relative to other elements to aid explication. Similar reference numerals are used in the figures to designate similar features. For clarity, all reference numerals are not necessarily displayed in all figures.

DETAILED DESCRIPTION

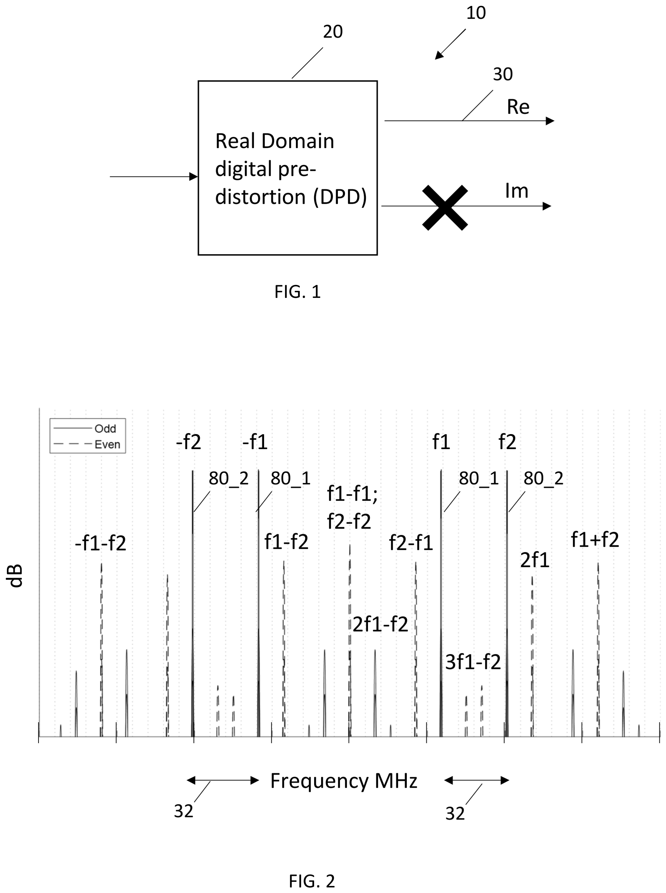

FIG. 1 illustrates an example of an apparatus 10 comprising means for:
digital pre-distortion 20 using real valued signals instead of complex valued signals to produce a pre-distorted real value signal 30.

In real domain, signals are real valued and represented by only one sequence of real numbers. In complex domain, signals are complex valued and represented by at least two sequences: the real and imaginary parts of complex numbers (or alternatively, their magnitude and phases).

In at least some examples, the apparatus 10 comprises a power amplifier 60 for amplification of the pre-distorted real valued signal 30_1.

The digital pre-distortion 20 is performed on the signal to be used as input for amplification. The digital pre-distortion 20 occurs before amplification of the pre-distorted real-valued signal 30. The pre-distorted real valued signal 30_1 is then amplified and transmitted.

In at least some examples, the apparatus 10 comprises a radio frequency circuitry including one or more antenna (or antenna ports) to enable the transmission of the amplified pre-distorted real value signal 30.

In at least some examples, the pre-distorted real valued signal 30 is configured to cancel distortion at the power amplifier 60 to linearize an output 61 of the power amplifier at the transmitting frequency.

In at least some examples, digital pre-distortion 20 characterizes the distortion by using a set of parameters/coefficients that are (at least partially) optimized for a certain operating point. The operating point is defined by the frequency of the carriers, output power, temperature of the device, etc. In some examples, the parameters/coefficients may be obtained by comparing a distorted real-valued signal/feedback signal 61, input signal 121 and pre-distorted signal 30. In some examples, the parameters/coefficients may be obtained by comparing at least two of the signal mentioned: feedback signal 61, input signal 121 and pre-distorted signal 30. In some examples, parameters for a specific model are obtained (could be polynomial model, artificial neural network,) so the signal to be transmitted in the next iteration can be used as input for this model. The output of the model is the pre-distorted signal.

In at least some examples, the pre-distorted real valued signal 30 is configured to cancel even-order distortion at the power amplifier 60 to linearize an output of the power amplifier 60 at the transmitting frequency. In at least some examples, the pre-distorted real valued signal 30 is configured to cancel even-order distortion at the power amplifier 60, for target frequencies, to linearize an output 61 of the power amplifier at the transmitting frequencies. In some examples, the target frequencies are the transmitting frequencies.

In some examples, the target frequencies could be outside the transmitting frequencies, to improve the linearity of the transmitting frequencies.

In at least some examples, the pre-distorted real valued signal 30 is additionally or alternatively configured to cancel odd-order distortion at the power amplifier 60 for a transmitting frequency, to linearize an output 61 of the power amplifier at the transmitting frequency.

In at least some examples, the pre-distorted real valued signal 30 is configured to cancel even-order distortion and odd-order distortion at a power amplifier 60 for a transmitting frequency, to linearize an output 61 of the power amplifier at the transmitting frequency.

The digital pre-distortion 20 in the real value signal 30 can provide in-band compensation for odd-order distortion and even-order distortion.

Referring to FIG 2, let us assume there are two carrier frequencies 80_1, 80_2 (for simplicity). The lowest frequency carrier 80_1 is at frequency f1 and the highest frequency carrier is at frequency f2. Harmonic distortion occurs at multiples of the carrier frequencies at f1, 2*f1, 3f*1..., f2, 2*f2, 3*f2...Intermodulation distortion can occur at linear combinations of the carrier frequencies e.g. n*f1 + m*f2 where n and m are positive and negative integers. The value |m|+|n| gives the order of the distortion.

If the transmitting bandwidth 32, b=f2-f1, is relatively small compared to the frequency f1, then the even-order intermodulation distortion (e.g. f2-f1) is outside the transmitting bandwidth 32 (f1 to f2) and is out-of-band (OOB) distortion, however odd-order intermodulation distortion (e.g. 2*f2-f1) produces in-band distortion that falls on the transmitting bandwidth 32.

If the transmitting bandwidth 32, b=f2-f1, is relatively large compared to the frequency f1, then the even order intermodulation distortion (e.g. 3*f1-f2) can fall on the transmitting bandwidth 32.

Furthermore, intermodulation distortion falling OOB modulates back to the transmitting band 32 via modulation of the drain voltage of the power amplifier. This is especially harming for the components falling at lower frequencies, since the frequency response there may contain resonances, making the cancellation of in-band distortion more computationally complex (need for more predistortion parameters for a satisfactory cancellation).

FIG 2 illustrates an example of frequency spectrum produced at the output of the power amplifier without pre-distortion when the transmitting bandwidth 32 is relatively large compared to the frequency f1. Even order intermodulation distortion can fall on the transmitting band. In this example, f1= 800-425/2 and f2= 800+425/2. It can be seen that the even order intermodulation distortion (3f1-f2) falls between f1 and f2.

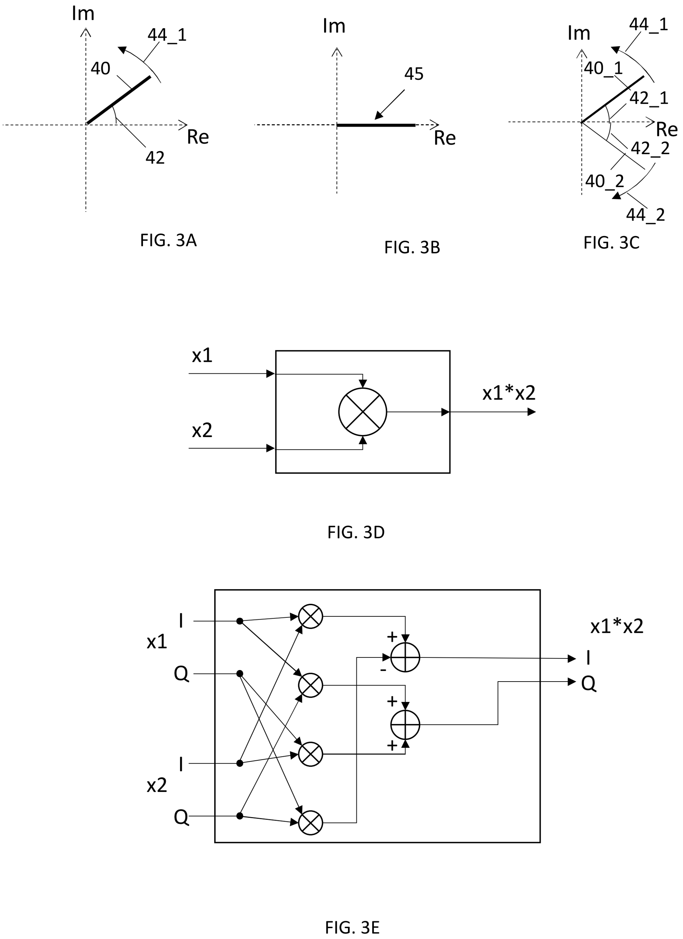

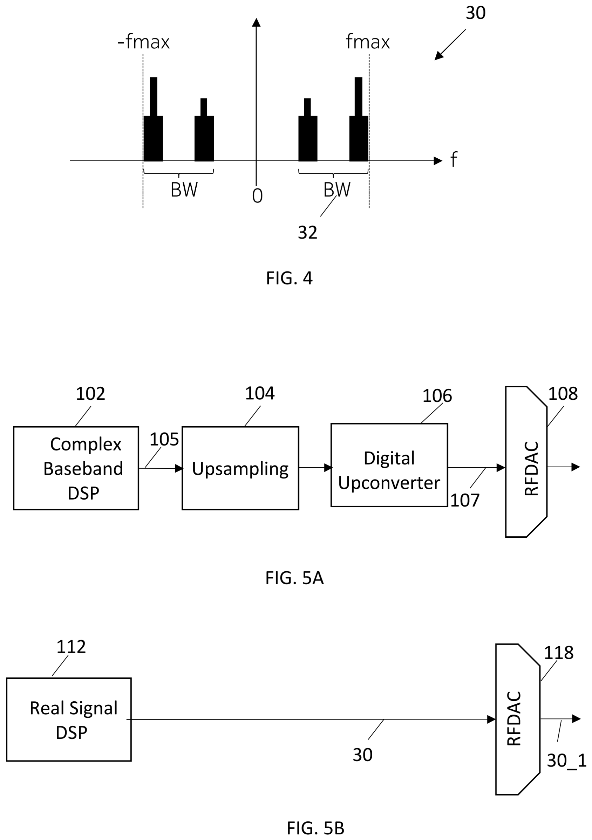

The following paragraphs, and FIGs 3A to 3C and FIG 4, highlight similarities and differences between a real valued signal and a complex valued signal.

Let us assume a function that is continuous and bounded over a finite range and can be presented as a Fourier transform based on complex valued signals (exp-iΦ). From Euler's formula expiΦ = cosΦ + j sinΦ = sin(Φ + π/2)+ j sin Φ, which is a complex valued sine-based signal.

FIG 3A illustrates an example of a complex valued sine-based signal component in an Argand diagram. The complex valued signal component can be represented as a phasor 40 that is rotating 44_1 in a single direction. It has only positive frequency (rate of change of the phase angle 42). For a complex continuous wave signal the spectrum of the complex valued sine-based signal will have only positive frequencies and will be asymmetric about DC (0 Hz).

FIG 3B illustrates an example of a real valued sine-based signal component in an Argand diagram. The real valued signal component can be represented as a phasor 45 that is stationary. In this example, the illustrated real valued signal is a pre-distorted real valued signal 30.

FIG 3C illustrates the real valued signal component of FIG 3B in an Argand diagram. The real valued signal component is represented as two phasors 40_1, 40_2 rotating symmetrically in opposite directions 44_1, 44_2 such that in combination they produce the stationary, real phasor of FIG 3B. The spectrum of the real valued signal will have positive frequencies (rate of change of phase angle 42_1) and negative frequencies (rate of change of phase angle 42_2) and will be symmetric (See FIG 2 and 4).

In FIG. 4, the available spectrum to represent the real valued signal 30 goes from minus half the sampling frequency (-fmax=-fs/2) to half the sampling frequency (fmax = fs/2), and there is a reflection symmetry between positive and negative frequencies. In some examples, the pre-distorted real valued signal 30 has a bandwidth 32 from zero frequency to half the sampling frequency.

A real valued signal (e.g. the pre-distorted real valued signal 30) is a signal that has a time-variable real component and no time-variable complex component or no complex component. At least some real valued signals (e.g. the pre-distorted real valued signal 30) can be modelled, using components based on non-rotating phasors 45 of stable (fixed) phase. A real valued signal component (e.g. the pre-distorted real valued signal 30) is a time-variable real valued signal that has a stable phase. It can also be modelled as two synchronized, counter-rotating phasors 40. A real valued signal (e.g. the pre-distorted real valued signal 30) is characterized by a conjugate symmetric power spectrum.

In contrast, a complex valued signal is a signal that has a time-variable real component and a time-variable complex component. At least some complex valued signals can be modelled, using components based on rotating phasors 40 of time-variable phase. The real part of the component of the complex signal is a 1D projection of the 2D phasor 40 onto the real axis. The complex part of the component of the complex signal is a 1D projection of the 2D phasor 40 onto the imaginary axis (which is orthogonal to the real axis). A complex valued signal is characterized by a conjugate asymmetric power spectrum.

A more general mathematical description of a real valued signal and a complex valued signal follows:
A transmitted band limited analog signal around a center frequency $f_c$ can be mathematically represented by

$$x_{RF}(t) = |m(t)| \cdot \cos\big(2\pi \cdot f_c \cdot t + \angle m(t)\big)$$

$x_{RF}(t)$ is the band limited complex signal $m(t)$ modulated to the center frequency $f_c$, resulting in a real valued signal. $|m(t)|$ and $\angle m(t)$ are the magnitude and phase of the complex valued signal $m(t)$.

As long as the band limited modulated signal $x_{RF}(t)$, which is a real valued signal, is contained in the positive frequency spectrum range from DC to half the sampling frequency, the sampled version of the signal, $x_{RF}(n)$ is a real valued signal and contains all the information of the signal $x_{RF}(t)$, and therefore can be processed without loss of information.

The complex valued baseband representation of this signal can be written as

$$x_{BB}(t) = LP\{x_{RF}(t) \cdot cos(2\pi \cdot fc \cdot t)\} - j \cdot LP\{x_{RF}(t) \cdot sin(2\pi \cdot fc \cdot t)\} = Re\{x_{BB}(t)\} + j \cdot Im\{x_{BB}(t)\}$$

with $LP\{\cdot\}$ is the low pass filtering operation that discards the spectral components around $2f_c$.

The real term of $x_{BB}(t)$ can be expanded as

$$Re\{x_{BB}(t)\} = LP\{x_{RF}(t) \cdot \cos(2\pi \cdot fc \cdot t)\}$$

$$= LP\{|m(t)| \cdot \cos(2\pi \cdot f_c \cdot t + \angle m(t)) \cdot \cos(2\pi \cdot fc \cdot t)\}$$

$$= LP\{ |m(t)| \cdot 0.5$$

$$\cdot (\cos(2\pi \cdot f_c \cdot t + \angle m(t) + 2\pi \cdot f_c \cdot t) + \cos(2\pi \cdot f_c \cdot t + \angle m(t) - 2\pi \cdot f_c \cdot t))\}$$

$$= LP\{ |m(t)| \cdot 0.5 \cdot (\cos(2 \cdot (2\pi \cdot f_c \cdot t) + \angle m(t)) + \cos(\angle m(t)))$$

$$Re\{x_{BB}(t)\} = 0.5 \cdot |m(t)| \cdot \cos(\angle m(t))$$

Similarly, the imaginary term of $x_{BB}(t)$ can be written as

$$Im\{x_{BB}(t)\} = LP\{-x_{RF}(t) \cdot \sin(2\pi \cdot fc \cdot t)\}$$

$$= LP\{-|m(t)| \cdot \cos(2\pi \cdot f_c \cdot t + \angle m(t)) \cdot \sin(2\pi \cdot fc \cdot t)\}$$

$$= LP\{-|m(t)| \cdot 0.5$$

$$\cdot (\sin(2\pi \cdot f_c \cdot t + 2\pi \cdot f_c \cdot t + \angle m(t)) + \sin(2\pi \cdot f_c \cdot t - 2\pi \cdot f_c \cdot t - \angle m(t)))\}$$

$$= LP\{- |m(t)| \cdot 0.5 \cdot (\sin(2 \cdot (2\pi \cdot f_c \cdot t) + \angle m(t)) + \sin(-\angle m(t)))$$

$$Im\{x_{BB}(t)\} = -0.5 \cdot |m(t)| \cdot \sin(-\angle m(t)) = 0.5 \cdot |m(t)| \cdot \sin(\angle m(t))$$

Following Euler's formula, $e^{j\alpha} = \cos(\alpha) + j \cdot \sin(\alpha)$

$$x_{BB}(t) = 0.5 \cdot |m(t)| \cdot (\cos(\angle m(t)) + j \cdot \sin(\angle m(t))) = 0.5 \cdot |m(t)| \cdot e^{j\angle m(t)} = 0.5 \cdot m(t)$$

The complex valued baseband representation of the signal has a smaller bandwidth than the real valued modulated representation of the same signal, and therefore can be processed with a reduced sampling frequency.

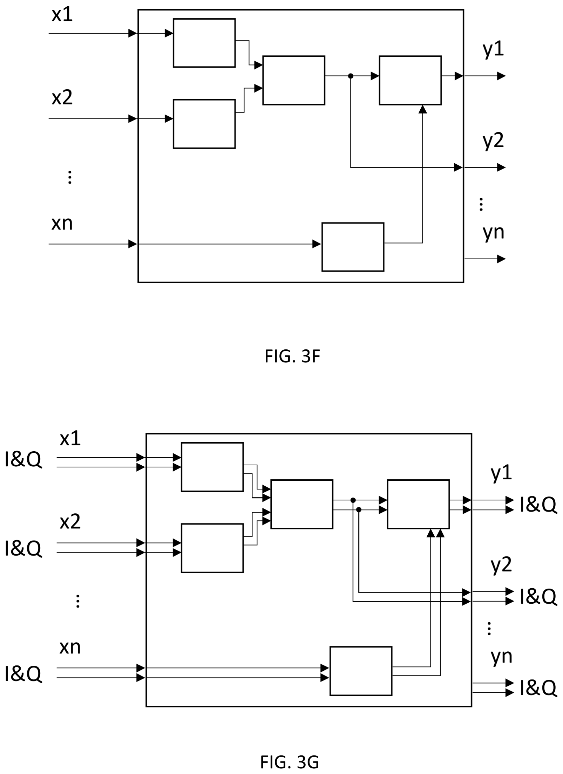

However, in the complex domain, all the processing blocks must be able to process complex valued signals, which require signal lanes and processing blocks with separate inputs for the real and imaginary parts (or alternatively, magnitude and phase). These blocks, as mentioned, operate at lower sampling rate but their operations are more computationally complex when compared to, in the real domain, the real signal processing blocks, that require only one input for each real valued signal. For example compare FIG 3D and 3E. FIG 3D is an exemplary real valued signal multiplication block (real domain) and FIG 3D is an exemplary complex valued signal multiplication block (complex domain). For example compare FIG 3F and 3G. FIG 3F is an exemplary real valued signal processing block (real domain) and FIG 3G is an exemplary complex valued signal processing block (complex domain).

Naturally, a complex baseband representation of the signal can be transformed back to a modulated and real valued signal with a mixing operation, which upconverts the complex band limited signal to the center frequency, on the positive frequency side, and extracts the real part of the signal.

$$x_{RF}(t) = Re\{x_{BB}(t) \cdot e^{j \cdot 2\pi \cdot f_c \cdot t}\}$$

These operations are commonly done either in the digital or analog domain, and it is called quadrature modulation.

In communications, the transmitted and received signals are often represented as Complex Baseband signals. This approach uses complex valued signals, composed of a real and an imaginary time sequence (I and Q components), which allows Hermitian spectral asymmetry. That means that negative and positive frequencies of a complex valued signal can be independent from each other, as opposed to real valued signals that imply a symmetric relation between the spectral content of the positive and negative frequencies. Complex valued signals can represent the spectra around the center frequency where the signals are modulated to, therefore representing the transmitted/received message and the distortion that interferes with it. However, it fails to represent other out of band components that have a big impact on the PA behavior.

A complex signal can be converted to a real signal. This could be achieved by, up-sampling, up-conversion to the center frequency, followed by a digital to analogue converter (DAC). In some examples, the DAC appears first and the up-conversion occurs in the analog domain. This could be achieved by separate DAC and analogue up conversions of the imaginary component and the real component before their combination. In some examples, as illustrated in FIG 5A, the DAC occurs last and the up-conversion and up-sampling occur in the digital domain. This is achieved by digital up-sampling 104 of the complex signal, digital up-conversion 106 of the complex signal (combine with a carrier frequency and discard the imaginary component) and then (higher frequency) DAC 108. The digital real signal 107 input to the DAC is produced from a processor generated complex signal 105 via up-sampling 104 and up-conversion 106.

The digital real signal input to the DAC can alternatively be produced, as illustrated in FIG 5B, from a digital signal processor block 112.

In at least some examples, the real valued signal is digital representation of the real valued analog RF signal (e.g. 30 is a digital representation of 30_1). This means that it is the signal right at the input/output of the RFDAC 118, without any effect from mixers and other intermediate blocks 104, 106.

In the example in FIG 5B, the pre-distorted real valued signal 30 is provided directly to a digital to analogue converter (DAC) 118 from a digital signal processing block 112, bypassing up-sampling and up-conversion blocks 104, 106 used for complex signals (if present).

The processing block 112 provides the pre-distorted real valued signal 30 at the transmitting frequency.

The processing block 112 can therefore have full control over the waveform at the input of the DAC 118. The output signal 30_1 from the RFDAC 118 is the analogue form of the pre-distorted real valued signal 30.

In the example, illustrated the signals to be transmitted (e.g. the pre-distorted real valued signal 30) are directly provided as real signals from the real digital signal processing block to the digital to analogue converter 118 which creates the waveform for transmission.

Thus, in at least some examples, the pre-distorted real valued signal 30 is provided, as a controlled waveform, directly from the digital signal processing block 112 to a digital to analogue converter (DAC) 118 at a transmitting frequency as a real signal.

The processing block 112 applies the digital pre-distortion to produce the pre-distorted real valued signal 30.

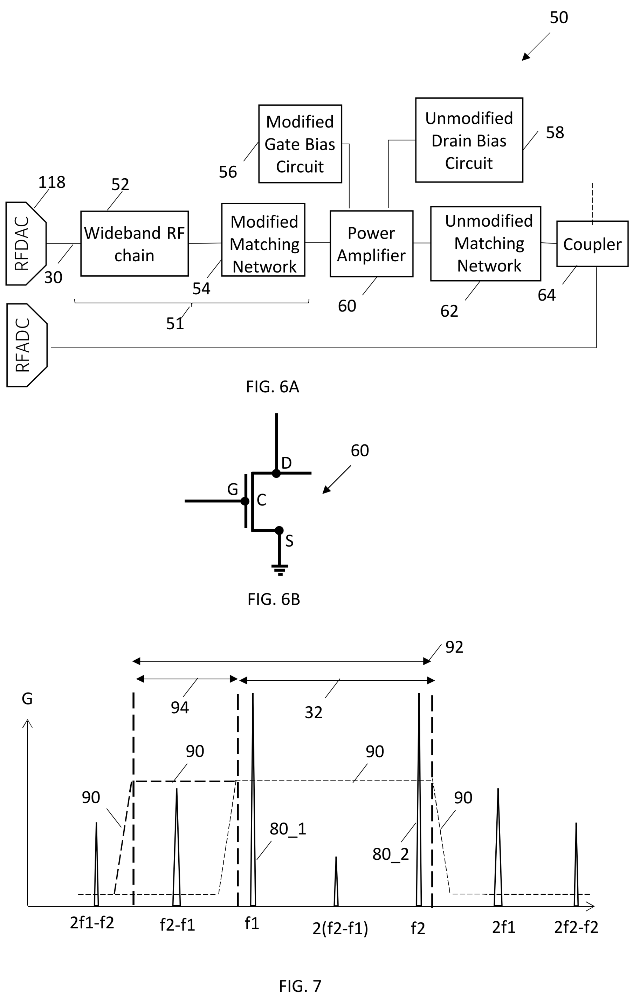

Fig. 6A illustrates an example of power amplification circuitry that receives the output signal 30_1 from the DAC. The output signal 30_1 is the analogue form of the pre-distorted real valued signal 30.

In this example, the power amplification circuitry 50 comprises a power amplifier 60 and an input path 51 to the power amplifier 60.

In this example, the power amplifier 60 is connected to adjacent upstream circuity (the DAC 118) via a matching network 54 and to downstream circuity 64 via a matching network 62.

In this example, the power amplifier 60 is a field effect transistor, for example as illustrated in FIG 6B. The field effect transistor comprises channel C between a drain D and a source S. The transconductance of the channel C is controlled by a voltage applied between the gate G and the source S. The gate G is coupled the upstream circuitry (e.g. DAC 118). The drain D is coupled the downstream circuitry 62.

In this example, the drain bias (the DC voltage between source and drain) is controlled by drain bias circuitry 58 and the gate bias (the DC voltage between source and gate) is controlled by gate bias circuitry 56.

The input path 51 provides a path for the pre-distorted real valued signal 30, after digital to analogue conversion by DAC 118, to the power amplifier 60.

The input path 51 is configured to have a bandwidth 92 that is extended significantly beyond a transmission bandwidth 32. FIG. 7 illustrates this.

In FIG 7 the pass band 90 of the input path 51 is illustrated. It has a bandwidth 92 that extends beyond the transmission bandwidth 32 required for carriers 80_1, 80_2

In this example, the input path 51 is configured to have a bandwidth 92 that is extended 94 significantly, beyond a transmission bandwidth 32, at frequencies below the transmission bandwidth 32.

In other examples, the input path 51 is configured to have a bandwidth 92 that is extended 94 significantly beyond a transmission bandwidth 32 at frequencies above the transmission bandwidth 32.

In other examples, the input path 51 is configured to have a bandwidth 92 that is not extended beyond a transmission bandwidth 32 and real valued predistortion reduces, for example, distortion components that fall in the transmission band 32.

In examples, the input path 51 is configured to have a bandwidth 92 that is extended 94 significantly beyond a transmission bandwidth 32 at frequencies above the transmission bandwidth 32 and at frequencies below the transmission bandwidth 32. The extension at frequencies above the transmission bandwidth 32 and the extension at frequencies below the transmission bandwidth 32 can be the same or different.

In this example, the input path 51 is configured to have a bandwidth 92 that is asymmetric with respect to a center frequency fc. The center frequency (fc) is at the midpoint between the frequency (f1) of the lowest frequency carrier 80_1 and the frequency (f2) of the highest frequency carrier 80_2. The transmission bandwidth 32 is greater than the difference between the frequency (f1) of the lowest frequency carrier 80_1 and the frequency (f2) of the highest frequency carrier 80_2. The transmission bandwidth 32 is centered at the center frequency fc. The transmission bandwidth 32 is symmetric with respect to the center frequency fc.

In at least some examples, the central frequency is at least several GHz and the transmission bandwidth 32 is hundreds of MHz. In at least some examples, the low-frequency edge of the passband bandwidth 92 of the input path 51 is moved more than 1Ghz below the center frequency.

In at least some examples, the low-frequency edge of the passband bandwidth 92 of the input path 51 is moved so that DC is within the passband bandwidth 92 (not illustrated).

The input path 51 includes the low frequencies in the passband of the RF path between the RFDAC and the power amplifier gate (the wideband RF chain 52 and the input matching network). This allows low frequency injections within the pre-distorted real valued signal 30 to reach the power amplifier 60 (e.g. the transistor gate G of the power amplifier 60).

This can be achieved by configuring the input matching circuitry 54 to the power amplifier 60 by tuning its impedance/reactance. This can, for example, include modification of a DC blocking capacitor present in the input matching network circuitry 54. The matching network circuitry 54 is configured to allow low frequencies to reach a gate node G of a power amplifier transistor.

In at least some examples, as a consequence of having a modified input path 51, the gate bias circuitry 56 is modified. The transistor gate bias circuit 56 is configured to compensate for low frequencies reaching a gate node G of a power amplifier 60 transistor. This can be achieved, for example, by modifying a gate bias resistor.

In at least some examples, as a consequence of having a modified input path 51, the drain bias circuitry 58 is modified.

The design of a matching network circuitry 54 and optionally the gate bias circuitry 56 allow low frequencies to reach the gate node G of the transistor.

Out-of-band digital pre-distortion 20 in the pre-distorted real valued signal 30 has an in-band effect.

The processing block 112 that performs the digital pre-distortion 20 with real valued signals is configured to adapt a signal for transmission at at least frequencies outside the transmission bandwidth 32 that have a capability to have an effect within the transmission bandwidth 32, for example, have the capability of affecting the linearity and linearizability of power amplifier 60.

The transmission bandwidth 32 is, in some examples, a frequency range that respects a certain linearity metric, for example, according to a standard specified adjacent channel leakage ration (ACLR).

Out-of-band digital pre-distortion 20 can mitigate distortion caused by distortion components mixing with each other and with the transmitted signals to generate in-band distortion.

Sub-band digital pre-distortion 20 in the pre-distorted real valued signal 30 can have an in-band effect. For example, low frequency digital pre-distortion 20 in the pre-distorted real valued signal 30 can have an in-band effect.

In some examples, the processing block 112 that performs the digital pre-distortion 20 with real valued signals is configured to adapt a signal for transmission at at least frequencies below the central frequency minus 4 times the first bandwidth 32.

In some examples, the processing block 112 that performs the digital pre-distortion 20 with real valued signals is configured such that the pre-distorted real valued signal 30 has a bandwidth that is extended towards DC but does not include DC or extended to include DC. Intermodulation distortion falling near DC can modulate back to the transmitting band 32 because of low frequency modulation of the drain voltage. The out-of-band digital pre-distortion 20 can mitigate this effect.

Sub-band digital pre-distortion 20 can mitigate distortion caused by distortion components mixing with each other and with the transmitted signals to generate in-band distortion

In some examples, the out-of-band or sub-band digital pre-distortion 20 cancels even-order components falling outside of the transmission band 32.

In some examples, the out-of-band or sub-band digital pre-distortion 20 does not cancel even-order components falling outside of the transmission band 32 but rather steers the phase and power of the resulting component. Adjusting the phase and power of the even-order component can impact the transmitting frequencies by reducing the distortion components there.

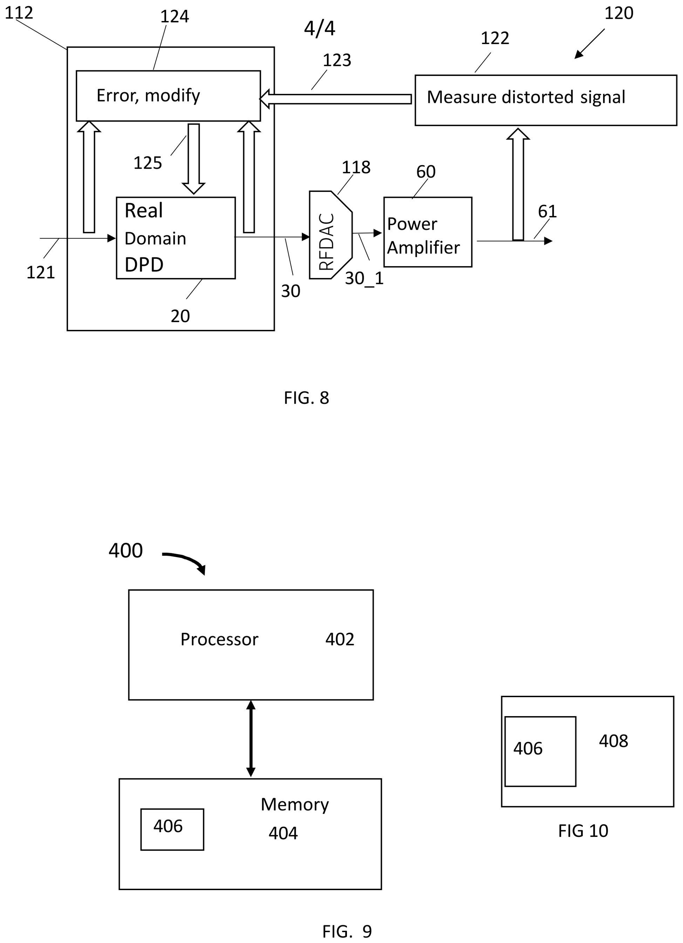

FIG. 8 illustrates an example of a control loop 120 for adjusting the pre-distorted real valued signal 30. The control loop 120 determines the digital pre-distortion 20 in the real domain, with real valued signals required to produce the pre-distorted real valued signal 30.

The digital signal processing block 112 applies digital pre-distortion 20 with real valued signals to an input signal 121 to produce the pre-distorted real valued signal 30 (the pre-distorted real valued signal).

The pre-distorted real valued signal 30 is converted from the digital domain to the analogue domain by the DAC 118 to produce the (analogue) pre-distorted real valued signal 30_1.

The analogue pre-distorted real valued signal 30_1 (result of pre-distorting the digital real valued signal 121) is amplified by the power amplifier 60 to produce transmission signal 61.

There may be other components/circuitry between the DAC 118 and the power amplifier 60, for example, pre-amplifiers, filters, phase-shifters, etc.

The power amplifier has distorted and amplified the (analogue) pre-distorted real valued signal 30_1 (result of pre-distorting the digital real valued signal 121)

Circuitry 122 is configured to measure the distorted signal, the feedback 61, at the output of a power amplifier 60.

Circuitry 124 is configured to determine an error based on the measurement of the distorted signal (the transmission signal 61) at the output of the power amplifier 60, the digital real valued pre-distorted signal 30 that was transmitted, and/or the signal 121. The objective of the control loop 120 is to adjust the digital pre-distortion 20 applied to the real-valued input signal 121 in the real domain to produce the pre-distorted real valued signal 30 such that the distorted real valued signal (the transmitted signal 61) approaches the real value input signal 121. The error therefore represents a difference between pre-distorted real valued signal 30 and (the distorted real valued signal (the transmitted signal 61) and/or real value input signal 121).

The objective of the control loop 120 is to adjust the digital pre-distortion 20 in the real domain such that the error is minimized or reduced below a threshold. The threshold can be defined, for example, by standard requirements or system specification requirements.

Thus, the digital pre-distortion is optimized based on the digital real valued feedback signal 61, the digital real valued pre-distorted signal 30 that was transmitted, and/or the real valued clean input signal 121 that was pre-distorted. The parameters/coefficients obtained from this optimization are used to pre-distort the real valued clean input signal 121 in the following iteration. Note digital pre-distortion is performed based on a comparison between real valued signals not complex representations.

Circuitry 124 provides data 125 to the digital signal processing block 112 which adjusts the digital pre-distortion 20 in the real domain to reduce the expected error.

These stages are repeated as a loop until the determined error meets a defined criterion, for example, is below a threshold value.

The digital signal processor 112 adapts coefficients for a model that generates the distorted components of the pre-distorted real valued signal 30 with an amplitude and phase capable of cancelling or reducing the distortion.

Digital pre-distortion characterizes the distortion by using a set of parameters/coefficients that are (at least partially) optimized for a certain operating point. The operating point is defined by the frequency of the carriers, output power, temperature of the device, etc.

In at least some examples, the pre-distorted real valued signal 30 is configured to cancel even-order distortion at the power amplifier 60 for a transmitting frequency, to linearize an output 61 of the power amplifier at the transmitting frequency.

In at least some examples, the pre-distorted real valued signal 30 is configured to cancel even-order distortion and odd-order distortion at a power amplifier 60 for a transmitting frequency, to linearize an output 61 of the power amplifier at the transmitting frequency.

In at least some examples, the pre-distorted real valued signal 30 is configured to cancel odd-order distortion at a power amplifier 60 for a transmitting frequency, to linearize an output 61 of the power amplifier at the transmitting frequency.

In at least some examples, the pre-distorted real valued signal 30 is out-of-band or sub-band digital pre-distortion 20 in the real domain that provides in-band compensation for distortion.

Nonlinear devices, such as the Power Amplifiers (PA), generate distortion components in the transmitted signal. This distortion is referred as Harmonic Distortion (HD) or Intermodulation Distortion products (IMD). These distortions can be modeled as the nth-order mixing product of the transmitted signal with itself. The distortion products can fall on top of the carrier frequencies, being called in-band distortion and degrade the quality of the transmitted signal. They can also fall near the carrier frequencies, being called out-of-band (OOB) distortion, which is limited by standard requirements to avoid inter-band interference. OOB emissions can also interfere with the receiving frequencies in FDD systems. These distortion related issues can be addressed by the design of more linear PAs. However, the restrictions imposed by linear PA design may limit other essential characteristics of the PA, such as bandwidth (BW), output power (Pout), gain, and efficiency. To achieve a good performing system and also meet the in-band and OOB requirements, linearization techniques are used.

The even-order IMDs are traditionally ignored by DPD since for low fractional bandwidths they fall away from the transmitting frequency bands (zone 1). Instead, they fall at lower frequencies (zone 0) and at higher frequencies above 2x the center frequency (zone 2, zone 4, ...), being usually possible to filter them out using an adequately designed passband filter. The odd-order IMDs, however, fall on the transmitting band (zone 1) as well as at higher frequencies (zone 3, zone 5, ...). Therefore, to handle odd-order distortion, linearization methods, such as Digital Predistortion (DPD) have been applied.

DPD consists in monitoring the output of a nonlinear system and adapting the transmitted signal with digital signal processing algorithms aiming to add extra components that can cancel out the odd-order IMDs that appear in the transmission band (zone 1). This is achieved by adapting the coefficients of a model based on the nonlinear PA. The more complex the model, the more coefficients and processing power are required.

Distortion components also mix with each other and with the transmitted signals generating additional distortion. Therefore, the even-order components can mix again with the carriers.

For high fractional bandwidths (transmission bandwidth/center frequency), the IMDs in zone 0 (below the transmitting band) start to overlap with the IMDs in zone 1 (the transmitting band). IMDs falling near DC may modulate back to the transmitting band. Since the drain impedance at those frequencies can contain resonances due to the interaction between the transistor parasitics, the matching networks, and the bias circuits, the modulated IMDs will carry the resonant behavior when mixing back to the transmitting band introducing what can be called memory effect. These memory effects make it more difficult to linearize, requiring more memory taps on the predistortion model.

In Macro Cell radios, it is common to use RF DACs 118 and RF ADCs with maximum sampling frequency of more than 5GS/s. One can operate them in the traditional manner, where IQ data (complex domain) is fed at their input as a complex signal to be up-sampled 104 and up-converted 106 by the RFDAC's built-in blocks prior to transmission.

In the example illustrated in FIG 5B, the RF DAC 118 is operated in Real Mode, where the signals to be transmitted are provided already at the transmitting frequency as real signals. When operating in Real Mode, one should have available as transmitting band the frequencies from near DC to more than 2.5GHz, with stable phase relation between the components transmitted and captured over the whole spectrum. This would enable the cancellation of even-order distortion overlapping with odd-order distortion for large fractional bandwidths.

Additionally, the upconverting procedure would also be within control of the processing block 112, making it possible to have full control over the waveform at the input of the DAC 118, rather than let the inaccessible built-in blocks 104, 106 modify it.

The cancellation can also be achieved for the IMDs falling on top of the carriers if signals are transmitted near DC,

When signals are transmitted at zone 0 (sub-band), they mix with the signals at zone 1 (in-band) generating additional IM products. By adapting the lower frequency signals (lower frequency injection), one can make additional IM products to compensate the IM products expected without the lower frequency injection. The zone 0 (sub-band) can be used as input for linearizing signals that can reach zone 1 (in-band) via the PAs nonlinear behavior and cancel the distortion at/around the carriers.

To enable lower frequency components to reach the transistor gate of the power amplifier, a modification on the input matching network, can be made. For example, a modification on the DC blocking capacitor present in the input matching network for a Class-AB amplifier.

For more advanced PA architectures, such as Doherty, similar modifications can be done. In the Doherty example, one can verify that the Hybrid coupler presented at the input has a DC path for one of the transistors. Together with a modification on the DC blocking capacitor and a few other components (such as the gate bias network resistor), one can implement a similar simplified low frequency path to allow the low frequency injections to reach the transistor gate

Operations in real domain are less computationally complex than in the complex-domain. For instance, while a multiplication between two complex numbers requires 4 multiplications and 3 summing operations, a multiplication between two real signals requires one single multiplication operation.

It is possible that the number of coefficients necessary for DPD adaptation in real domain is larger than for complex domain. According to a rough estimation, if the computation complexity is dominated by multiplications, which are estimated to be Nx (e.g. 4x) less complex in real signal domain, one could allow Nx the sampling rate for same computation complexity with the addition of the capacity to model even order distortion.

Fig 9 illustrates an example of a controller 400 suitable for use in an apparatus 10. Implementation of a controller 400 may be as controller circuitry. The controller 400 may be implemented in hardware alone, have certain aspects in software including firmware alone or can be a combination of hardware and software (including firmware).

As illustrated in Fig 9 the controller 400 may be implemented using instructions that enable hardware functionality, for example, by using executable instructions 406 in a general-purpose or special-purpose processor 402 that may be stored on a machine readable storage medium (disk, memory etc.) to be executed by such a processor 402.

The processor 402 is configured to read from and write to the memory 404. The processor 402 may also comprise an output interface via which data and/or commands are output by the processor 402 and an input interface via which data and/or commands are input to the processor 402.

The memory 404 stores instructions, program, or code 406 that controls the operation of the apparatus 10 when loaded into the processor 402. The computer program instructions, program or code am 406, provide the logic and routines that enables the apparatus 10 to perform the methods illustrated in the accompanying FIGs. The processor 402 by reading the memory 404 is configured to load and execute the instructions, program, or code 406.

The apparatus 10 comprises:

at least one processor 402; and
at least one memory 404 storing instructions that, when executed by the at least one processor 402, cause the apparatus at least to perform:
determine a pre-distorted real valued signal 30, wherein the determination of the pre-distorted real valued signal (30) comprises: applying a digital pre-distortion (20) in the real domain to a real-valued input signal (121) to obtain the pre-distorted real valued signal (30) to be transmitted to be transmitted to power amplifier; measuring an output of the power amplifier representative of a distorted real-valued signal (61); determining an error based on the distorted real-valued signal (61) and at least one of the a) the real-valued input signal (121) b) the digital pre-distorted signal (30); modifying the digital pre-distortion (20) in the real domain based on the determined error.

The digital pre-distortion 20 is performed based on the digital real valued feedback signal 61, the digital real valued pre-distorted signal 30 that was transmitted, and/or the real valued clean input signal 121 that was pre-distorted.

In at least some examples, digital pre-distortion 20 of the real valued signal in the real domain adapts a real valued signal for transmission at at least frequencies outside the bandwidth of transmission frequencies. In at least some example, digital pre-distortion of the real valued signal in the real domain adapts a real valued signal for transmission at at least frequencies outside the bandwidth of transmission frequencies that have a capability to have an effect within the first bandwidth.

As illustrated in Fig 10, the instructions, program, or code 406 may arrive at the apparatus 10 via any suitable delivery mechanism 408. The delivery mechanism 408 may be, for example, a machine readable medium, a computer-readable medium, a non-transitory computer-readable storage medium, a computer program product, a memory device, a record medium such as a Compact Disc Read-Only Memory (CD-ROM) or a Digital Versatile Disc (DVD) or a solid-state memory, an article of manufacture that comprises or tangibly embodies the computer program 406. The delivery mechanism may be a signal configured to reliably transfer the computer program 406. The apparatus 10 may propagate or transmit the computer program 406 as a computer data signal.

The term "non-transitory" as used herein, is a limitation of the medium itself (i.e., tangible, not a signal) as opposed to a limitation on data storage persistency (e.g., RAM vs. ROM).

The computer program instructions may be comprised in a computer program, a non-transitory computer readable medium, a computer program product, a machine readable medium. In some but not necessarily all examples, the computer program instructions may be distributed over more than one computer program.

Although the memory 404 is illustrated as a single component/circuitry it may be implemented as one or more separate components/circuitry some or all of which may be integrated/removable and/or may provide permanent/semi-permanent/ dynamic/cached storage.

Although the processor 402 is illustrated as a single component/circuitry it may be implemented as one or more separate components/circuitry some or all of which may be integrated/removable. The processor 402 may be a single core or multi-core processor.

References to 'computer-readable storage medium', 'computer program product', 'tangibly embodied computer program' etc. or a 'controller', 'computer', 'processor' etc. should be understood to encompass not only computers having different architectures such as single /multi- processor architectures and sequential (Von Neumann)/parallel architectures but also specialized circuits such as field-programmable gate arrays (FPGA), application specific circuits (ASIC), signal processing devices and other processing circuitry. References to computer program, instructions, code etc. should be understood to encompass software for a programmable processor or firmware such as, for example, the programmable content of a hardware device whether instructions for a processor, or configuration settings for a fixed-function device, gate array or programmable logic device etc.

As used in this application, the term 'circuitry' may refer to one or more or all the following:

(a) hardware-only circuitry implementations (such as implementations in only analog and/or digital circuitry) and
(b) combinations of hardware circuits and software, such as (as applicable):
a combination of analog and/or digital hardware circuit(s) with software/firmware and any portions of hardware processor(s) with software (including digital signal processor(s)), software, and memory or memories that work together to cause an apparatus, such as a mobile phone or server, to perform various functions and
(c) hardware circuit(s) and or processor(s), such as a microprocessor(s) or a portion of a microprocessor(s), that requires software (for example, firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor and its (or their) accompanying software and/or firmware. The term circuitry also covers, for example and if applicable to the claim element, a baseband integrated circuit for a mobile device or a similar integrated circuit in a server, a cellular network device, or other computing or network device.

The blocks illustrated in the accompanying Figs may represent steps in a method and/or sections of code in the computer program 406. The illustration of a particular order to the blocks does not necessarily imply that there is a required or preferred order for the blocks and the order and arrangement of the block may be varied. Furthermore, it may be possible for some blocks to be omitted.

As used here 'module' refers to a unit or apparatus that excludes certain parts/components that would be added by an end manufacturer or a user. The apparatus 10 can, for example be a module. A controller 400 of the apparatus 10 can, for example be a module.

Where a structural feature has been described, it may be replaced by means for performing one or more of the functions of the structural feature whether that function or those functions are explicitly or implicitly described.

The above-described examples find application as enabling components of:

automotive systems; telecommunication systems; electronic systems including consumer electronic products; distributed computing systems; media systems for generating or rendering media content including audio, visual and audio visual content and mixed, mediated, virtual and/or augmented reality; personal systems including personal health systems or personal fitness systems; navigation systems; user interfaces also known as human machine interfaces; networks including cellular, non-cellular, and optical networks; ad-hoc networks; the internet; the internet of things; virtualized networks; and related software and services.

The apparatus can be provided in an electronic device, for example, a mobile terminal, according to an example of the present disclosure. It should be understood, however, that a mobile terminal is merely illustrative of an electronic device that would benefit from examples of implementations of the present disclosure and, therefore, should not be taken to limit the scope of the present disclosure to the same. While in certain implementation examples, the apparatus can be provided in a mobile terminal, other types of electronic devices, such as, but not limited to: mobile communication devices, hand portable electronic devices, wearable computing devices, portable digital assistants (PDAs), pagers, mobile computers, desktop computers, televisions, gaming devices, laptop computers, cameras, video recorders, GPS devices and other types of electronic systems, can readily employ examples of the present disclosure. Furthermore, devices can readily employ examples of the present disclosure regardless of their intent to provide mobility.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to 'comprising only one...' or by using 'consisting.'

In this description, the wording 'connect', 'couple' and 'communication' and their derivatives mean operationally connected/coupled/in communication. It should be appreciated that any number or combination of intervening components can exist (including no intervening components), i.e., to provide direct or indirect connection/coupling/communication. Any such intervening components can include hardware and/or software components.

As used herein, the term "determine/determining" (and grammatical variants thereof) can include, not least: calculating, computing, processing, deriving, measuring, investigating, identifying, looking up (for example, looking up in a table, a database, or another data structure), ascertaining and the like. Also, "determining" can include receiving (for example, receiving information), accessing (for example, accessing data in a memory), obtaining and the like. Also, " determine/determining" can include resolving, selecting, choosing, establishing, and the like.

In this description, reference has been made to various examples. The description of features or functions in relation to an example indicates that those features or functions are present in that example. The use of the term 'example' or 'for example' or 'can' or 'may' in the text denotes, whether explicitly stated or not, that such features or functions are present in at least the described example, whether described as an example or not, and that they can be, but are not necessarily, present in some of or all other examples. Thus 'example', 'for example', 'can', or 'may' refers to a particular instance in a class of examples. A property of the instance can be a property of only that instance or a property of the class or a property of a sub-class of the class that includes some but not all the instances in the class. It is therefore implicitly disclosed that a feature described with reference to one example but not with reference to another example, can where possible be used in that other example as part of a working combination but does not necessarily have to be used in that other example.

As used herein, "at least one of the following: " and "at least one of " and similar wording, where the list of two or more elements are joined by "and" or "or" mean at least any one of the elements, or at least any two or more of the elements, or at least all the elements.

Although examples have been described in the preceding paragraphs with reference to various examples, it should be appreciated that modifications to the examples given can be made without departing from the scope of the claims.

Features described in the preceding description may be used in combinations other than the combinations explicitly described above.

Although functions have been described with reference to certain features, those functions may be performable by other features whether described or not.

The description of a feature, such as an apparatus or a component of an apparatus, configured to perform a function, or for performing a function, should additionally be considered to also disclose a method of performing that function. For example, description of an apparatus configured to perform one or more actions, or for performing one or more actions, should additionally be considered to disclose a method of performing those one or more actions with or without the apparatus.

Although features have been described with reference to certain examples, those features may also be present in other examples whether described or not.

The term 'a', 'an' or 'the' is used in this document with an inclusive not an exclusive meaning. That is any reference to X comprising a/an/the Y indicates that X may comprise only one Y or may comprise more than one Y unless the context clearly indicates the contrary. If it is intended to use 'a', 'an' or 'the' with an exclusive meaning then it will be made clear in the context. In some circumstances the use of 'at least one' or 'one or more' may be used to emphasis an inclusive meaning but the absence of these terms should not be taken to infer any exclusive meaning.

The presence of a feature (or combination of features) in a claim is a reference to that feature or (combination of features) itself and to features that achieve substantially the same technical effect (equivalent features). The equivalent features include, for example, features that are variants and achieve substantially the same result in substantially the same way.

The equivalent features include, for example, features that perform substantially the same function, in substantially the same way to achieve substantially the same result.

In this description, reference has been made to various examples using adjectives or adjectival phrases to describe characteristics of the examples. Such a description of a characteristic in relation to an example indicates that the characteristic is present in some examples exactly as described and is present in other examples substantially as described.

The above description describes some examples of the present disclosure however those of ordinary skill in the art will be aware of possible alternative structures and method features which offer equivalent functionality to the specific examples of such structures and features described herein above and which for the sake of brevity and clarity have been omitted from the above description. Nonetheless, the above description should be read as implicitly including reference to such alternative structures and method features which provide equivalent functionality unless such alternative structures or method features are explicitly excluded in the above description of the examples of the present disclosure.

Whilst endeavoring in the foregoing specification to draw attention to those features believed to be of importance the Applicant may seek protection via the claims in respect of any patentable feature or combination of features hereinbefore referred to and/or shown in the drawings whether or not emphasis has been placed thereon.

## Claims

1. An apparatus comprising:

   a digital signal processor circuitry (112) comprising a digital predistortion circuitry;
   a power amplifier (60);
   at least one processor (402); and
   at least one memory (404) comprising instructions which, when executed by the at least one processor, cause the apparatus at least to:
   determine a pre-distorted real valued signal 30, wherein the determination of the pre-distorted real valued signal (30) comprises:

   (i) applying a digital pre-distortion (20) in the real domain to a real-valued input signal (121) to obtain the pre-distorted real valued signal (30) to be transmitted to the power amplifier;
   (ii) measuring an output of the power amplifier representative of a distorted real-valued signal (61);
   (iii) determining an error based on the distorted real-valued signal (61) and at least one of the a) the real-valued input signal (121) b) the digital pre-distorted signal (30);
   (iv) modifying the digital pre-distortion in the real domain based on the determined error.

2. The apparatus as claimed in claim 1, wherein the apparatus is further caused to transmit the pre-distorted real valued signal over a first bandwidth of transmission frequencies and to adapt a real valued signal for transmission at at least frequencies outside the first bandwidth that have a capability to have an effect within the first bandwidth.

3. The apparatus as claimed in claim 1, wherein the real valued signal is a time-variable real valued signal and has a bandwidth from zero frequency, DC, to half the sampling frequency.

4. The apparatus as claimed in any preceding claim, wherein the pre-distorted real valued signal is provided, as a controlled waveform, directly from a digital signal processing block to a digital to analogue converter at a target frequency as a real valued signal.

5. The apparatus as claimed in any preceding claim, wherein the pre-distorted real valued signal is provided directly to a digital to analogue converter from a digital signal processor block, bypassing up-sampling and up-conversion blocks used for complex valued signals.

6. The apparatus as claimed in any preceding claim, wherein the pre-distorted real valued signal is configured to cancel at least one of i) even-order distortion ii) odd-order distortion at a power amplifier for a transmitting frequency, to linearize an output of the power amplifier at the transmitting frequency.

7. The apparatus as claimed in any preceding claim, wherein the apparatus is further caused to adapt the digital predistortion coefficients for a model that generates the distorted components with an amplitude and phase capable of cancelling distortion generated by a power amplifier.

8. The apparatus as claimed in any preceding claim, wherein the apparatus is further caused to transmit the pre-distorted real valued signal over a first bandwidth of transmission frequencies,
and to adapt a signal for transmission at at least frequencies below a frequency of the transmitted carrier of lowest frequency or above a frequency of the transmitted carrier of highest frequency.

9. The apparatus as claimed in any preceding claim, comprising an input path for the pre-distorted real valued signal to a power amplifier wherein the input path is configured to have a bandwidth that is extended significantly beyond a transmission bandwidth.

10. The apparatus as claimed in claim 9, wherein the input path is configured to have a bandwidth that is extended significantly beyond a transmission bandwidth at frequencies below the transmission bandwidth.

11. The apparatus as claimed in claim 10, wherein the input path is configured to have a bandwidth that is extended to include DC.

12. The apparatus as claimed in any preceding claim, comprising a matching network configured to allow low frequencies to reach a gate node of a power amplifier transistor.

13. The apparatus as claimed in any preceding claim, comprising a transistor bias circuit configured to allow low frequencies coming from a power amplifier input to reach a gate node of a transistor of the power amplifier.

14. An electronic device comprising the apparatus as claimed in any preceding claim.

15. A method comprising:
determining a pre-distorted real valued signal 30, wherein the determination of the pre-distorted real valued signal (30) comprises:

applying a digital pre-distortion (20) in the real domain to a real-valued input signal (121) to obtain the pre-distorted real valued signal (30) to be transmitted to be transmitted to a power amplifier;
measuring an output of the power amplifier representative of a distorted real-valued signal (61);
determining an error based on the distorted real-valued signal (61) and at least one of the a) the real-valued input signal (121) b) the digital pre-distorted signal (30);
modifying the digital pre-distortion in the real domain based on the determined error.

FIG. 1

FIG. 2

FIG. 3A

FIG. 3B

FIG. 3C

FIG. 3D

FIG. 3E

FIG. 3F

FIG. 3G

**30**

-fmax          fmax

BW          0          BW

**32**

FIG. 4

**102**                **104**                **106**        **108**

| Complex Baseband DSP | 105 | Upsampling | Digital Upconverter | 107 | RFDAC |

FIG. 5A

**112**                        **118**

| Real Signal DSP |          30          | RFDAC | 30_1 |

FIG. 5B

50

FIG. 6A

FIG. 6B

G

2f1-f2    f2-f1    f1    2(f2-f1)    f2    2f1    2f2-f2

FIG. 7

4/4

FIG. 8

FIG. 9

FIG 10

**EUROPEAN SEARCH REPORT**

Application Number

EP 25 21 3532

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/274560 A1 (PRATT PATRICK [IE]) 27 August 2020 (2020-08-27) * paragraphs [0002] - [0107]; figures 1-14 * | 1-15 | INV. H03F1/32 H03F3/19 H03F3/24 H04B1/04 |
| | ----- | | |
| A | US 2024/195395 A1 (MÄNNCHEN ANDREAS [DE] ET AL) 13 June 2024 (2024-06-13) * paragraphs [0002] - [0169]; figures 1-14 * | 1-15 | |
| | ----- | | |

TECHNICAL FIELDS SEARCHED (IPC)

H03F
H04B

The present search report has been drawn up for all claims

| Place of search | Date of completion of the search | Examiner |
|---|---|---|
| The Hague | 19 February 2026 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 3532

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2026

| Patent document cited in search report | Publication date | Patent family member(s) | Publication date |
|---|---|---|---|
| US 2020274560 A1 | 27-08-2020 | NONE | |
| US 2024195395 A1 | 13-06-2024 | DE 102021208318 A1 | 02-02-2023 |
| | | EP 4378075 A1 | 05-06-2024 |
| | | JP 7739589 B2 | 16-09-2025 |
| | | JP 2024529983 A | 14-08-2024 |
| | | US 2024195395 A1 | 13-06-2024 |
| | | WO 2023006259 A1 | 02-02-2023 |

EPO FORM P0459

For more details about this annex : see Official Journal of the European Patent Office, No. 12/82